# EUROPEAN PATENT APPLICATION

(11) **EP 4 742 853 A1**
(43) Date of publication of application: **13.05.2026**
(21) Application number: 25202233.0
(22) Date of filing: 15.09.2025
(51) Int. Cl.: H10D 30/01, H10D 30/62, H10D 62/10, H10D 64/27, H10D 64/66, H10D 30/67, H10D 84/01

(54) **SEMICONDUCTOR DEVICE AND METHOD OF FABRICATING THE SAME**

(30) Priority: 07.11.2024 KR 20240156884
(71) Applicant: Samsung Electronics Co., Ltd., Suwon-si, Gyeonggi-do 16677 (KR)
(72) Inventor: KIM, Deokhwan, 16677 Suwon-si (KR); KIM, Sungmin, 16677 Suwon-si (KR); KIM, Jaemyeong, 16677 Suwon-si (KR); KIM, Jeonggeol, 16677 Suwon-si (KR); LEE, Yongkyung, 16677 Suwon-si (KR)
(74) Representative: Elkington and Fife LLP

(57) **Abstract**

A semiconductor device includes: a substrate; a channel layer having a fin shape and protruding from the substrate in a first direction perpendicular to an upper surface of the substrate; an external gate electrode on a first side surface of the channel layer, a second side surface of the channel layer that is opposite to the first side surface, and an upper surface of the channel layer; and an internal gate electrode contacting a lower surface of the channel layer, wherein the internal gate electrode includes a material that is different from a material from of the external gate electrode.

## Description

### FIELD OF THE INVENTION

The disclosure relates to a semiconductor device and a method of fabricating the same.

### BACKGROUND OF THE INVENTION

In semiconductor devices such as fin field effect transistors (FinFET), a channel may be formed in a fin shape perpendicularly protruding from a substrate, and a gate electrode may surround three sides of the channel. Semiconductor devices having such a three-dimensional shape may exhibit high performance and implement a high integration density.

Information disclosed in this Background section has already been known to or derived by the inventors before or during the process of achieving the embodiments of the present application, or is technical information acquired in the process of achieving the embodiments. Therefore, it may contain information that does not form the prior art that is already known to the public.

### SUMMARY OF THE INVENTION

Provided are a semiconductor device and a method of fabricating the same.

Additional aspects will be set forth in part in the description which follows and, in part, will be apparent from the description, or may be learned by practice of the presented embodiments of the disclosure.

According to an aspect of the disclosure, a semiconductor device includes: a substrate; a channel layer having a fin shape and protruding from the substrate in a first direction perpendicular to an upper surface of the substrate; an external gate electrode on a first side surface of the channel layer, a second side surface of the channel layer that is opposite to the first side surface, and an upper surface of the channel layer; and an internal gate electrode contacting a lower surface of the channel layer, wherein the internal gate electrode includes a material that is different from a material from of the external gate electrode.

The material of the internal gate electrode may have etch selectivity with respect to the external gate electrode.

The material of the internal gate electrode and the material of the external gate electrode may include at least one of metal, metal nitride, metal oxide, and doped polysilicon.

The external gate electrode may include a first conductive layer on the channel layer and a second conductive layer on the first conductive layer.

The channel layer may include a Group IV semiconductor, a Group III-V semiconductor compound, an oxide semiconductor, a nitride semiconductor, an oxynitride semiconductor, a two-dimensional semiconductor, quantum dots, or an organic semiconductor.

The internal gate electrode may include: an internal conductive layer including a material that is different from the material of the external gate electrode; and a barrier layer on an upper surface of the internal conductive layer and a lower surface of the internal conductive layer.

According to an aspect of the disclosure, a semiconductor device includes: a substrate; a first unit device on the substrate; and a second unit device on the substrate and spaced apart from the first unit device, wherein each of the first unit device and the second unit device may include: a channel layer having a fin shape and protruding from the substrate in a first direction perpendicular to an upper surface of the substrate; an external gate electrode on a first side surface of the channel layer, a second side surface of the channel layer that is opposite to the first side surface, and an upper surface of the channel layer; and an internal gate electrode contacting a lower surface of the channel layer, and wherein the internal gate electrode includes a material that is a different from a material from of the external gate electrode.

The material of the internal gate electrode of each of the first unit device and the second unit device may have etch selectivity with respect to the external gate electrode.

In a second direction that is perpendicular to the first direction, a thickness of the external gate electrode of the first unit device is different from a thickness of the external gate electrode of the second unit device.

The external gate electrode of each of the first unit device and the second unit device may include a first conductive layer on the channel layer and a second conductive layer on the first conductive layer.

In a second direction that is perpendicular to the first direction, a thickness of the first conductive layer of the first unit device is different from a thickness of the first conductive layer of the second unit device.

The material of the internal gate electrode and the material of the external gate electrode of each of the first unit device and the second unit device may include at least one of metal, metal nitride, metal oxide, and doped polysilicon.

The channel layer of each of the first unit device and the second unit device may include a Group IV semiconductor, a Group III-V semiconductor compound, an oxide semiconductor, a nitride semiconductor, an oxynitride semiconductor, a two-dimensional semiconductor, quantum dots, or an organic semiconductor.

The internal gate electrode of each of the first unit device and the second unit device may include: an internal conductive layer including a material that is different from the material of the external gate electrode; and a barrier layer on an upper surface of the internal conductive layer and a lower surface of the internal conductive layer.

According to an aspect of the disclosure, a method of fabricating a semiconductor device, includes: forming a first channel layer and a second channel layer on a substrate that extend in a first direction perpendicular to an upper surface of the substrate; forming a first through-hole in a lower of the first channel layer and a second through-hole in a lower portion of the second channel layer; forming a first internal gate electrode filling the first through-hole and a second internal gate electrode filling and the second through-hole; forming a first external gate material layer on the substrate, the first external gate material layer covering the first channel layer, the first internal gate electrode, the second channel layer and the second internal gate electrode; selectively etching and removing the first external gate material layer in areas in which the first external gate material layer covers the first channel layer and the first internal gate electrode; forming a second external gate material layer on the first external gate material layer covering the first channel layer, the first internal gate electrode, the second channel layer, and the second internal gate electrode; forming a first external gate electrode on the first channel layer and the first internal gate electrode; and forming a second external gate electrode on the second channel layer and the second internal gate electrode, wherein the first internal gate electrode includes a material that is different from a material of the first external gate electrode, and the second internal gate electrode includes a material that is different from a materials of the second external gate electrode.

A thickness of the second external gate electrode may be different from a thickness of the first external gate electrode.

The first through-hole and the second through-hole may be formed in a second direction that is perpendicular to the first direction.

The forming the first internal gate electrode and the second internal gate electrode may include: forming an internal gate material layer in each of the first channel layer and the second channel layer to fill the first through-hole and the second through-hole; and etching and removing the internal gate material layer such that the internal gate material layer remains only in the first through-hole and the second through-hole.

The internal gate material layer may include a material having etch selectivity with respect to the first external gate material layer.

The first internal gate electrode may include a first internal conductive layer including a material that is different from the material of the first external gate electrode and a barrier layer on an upper surface of the first internal conductive layer and a lower surface of the first internal conductive layer, and the second internal gate electrode may include a second internal conductive layer including a material that is different from the material of the second external gate electrode and a barrier layer on an upper surface of the second internal conductive layer and a lower surface of the second internal conductive layer.

### BRIEF DESCRIPTION OF DRAWINGS

The above and other aspects, features, and advantages of certain embodiments of the disclosure will be more apparent from the following description taken in conjunction with the accompanying drawings, in which:
FIG. 1 is a perspective view of a semiconductor device according to one or more embodiments;
FIG. 2 is a cross-sectional view of the semiconductor device taken along line I-I' of FIG. 1 according to one or more embodiments;
FIG. 3 is a cross-sectional view of a semiconductor device according to one or more embodiments;
FIG. 4 is a cross-sectional view of a semiconductor device according to one or more embodiments;
FIG. 5 is a cross-sectional view of a semiconductor device according to one or more embodiments;
FIG. 6 is a cross-sectional view of a semiconductor device according to one or more embodiments;
FIGS. 7A to 7G are cross-sectional views illustrating a method of fabricating a semiconductor device, according to one or more embodiments;
FIGS. 8A to 8C are cross-sectional views illustrating a method of fabricating a semiconductor device, according to a comparative example; and
FIGS. 9A to 9H are cross-sectional views illustrating a method of fabricating a semiconductor device, according to one or more embodiments.

### DETAILED DESCRIPTION

Reference will now be made in detail to embodiments, examples of which are illustrated in the accompanying drawings, wherein like reference numerals refer to like elements throughout. In this regard, the embodiments may have different forms and should not be construed as being limited to the descriptions set forth herein. Accordingly, the embodiments are merely described below, by referring to the figures, to explain aspects.

Sizes of each constituent element in the drawings may be exaggerated for convenience of explanation and clarity. As embodiments described below are examples, other modifications may be made from the embodiments.

When a constituent element is disposed "above" or "on" to another constituent element, the constituent element may include not only an element directly contacting on the upper/lower/left/right sides of the other constituent element, but also an element disposed above/under/left/right the other constituent element in a non-contact manner. As used herein, the singular forms "a," "an," and "the" are intended to include the plural forms as well, unless the context clearly indicates otherwise. Furthermore, throughout the specification, when a portion "includes" an element, another element may be further included, rather than excluding the existence of the other element, unless otherwise described.

Also, the operations of all methods described herein can be performed in any suitable order unless otherwise indicated herein or otherwise clearly contradicted by context. Embodiments are not limited to the described order of the steps.

Furthermore, terms such as "... portion," "... unit," "... module," and "... block" stated in the disclosure may signify a unit to process at least one function or operation and the unit may be embodied by hardware, software, or a combination of hardware and software.

Furthermore, the connecting lines, or connectors shown in the various figures presented are intended to represent functional relationships and/or physical or logical couplings between the various elements. It should be noted that many alternative or additional functional relationships, physical connections or logical connections may be present in a practical device.

The use of any and all examples, or language (e.g., "such as") provided herein, is intended merely to better illuminate the disclosure and does not pose a limitation on the scope of the disclosure unless otherwise claimed.

As used herein, expressions such as "at least one of," when preceding a list of elements, modify the entire list of elements and do not modify the individual elements of the list. For example, the expression, "at least one of a, b, and c," should be understood as including only a, only b, only c, both a and b, both a and c, both b and c, or all of a, b, and c.

It will be understood that when an element or layer is referred to as being "over," "above," "on," "below," "under," "beneath," "connected to" or "coupled to" another element or layer, it can be directly over, above, on, below, under, beneath, connected or coupled to the other element or layer or intervening elements or layers may be present. In contrast, when an element is referred to as being "directly over," "directly above," "directly on," "directly below," "directly under," "directly beneath," "directly connected to" or "directly coupled to" another element or layer, there are no intervening elements or layers present.

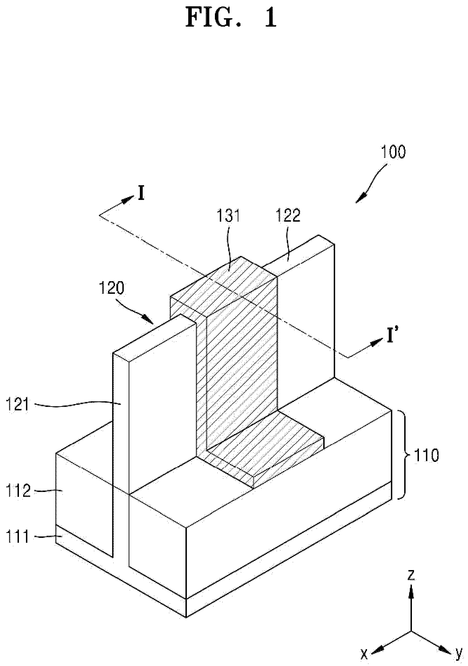

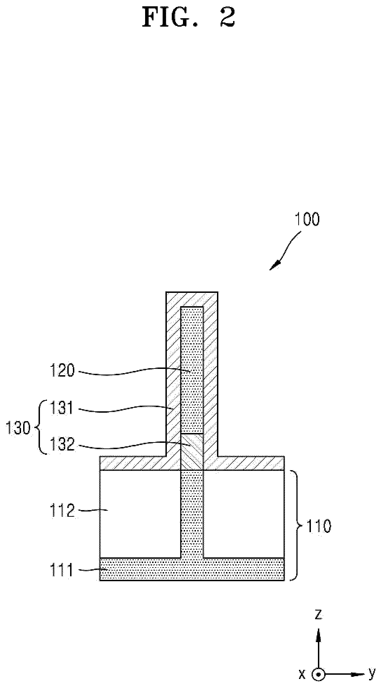

FIG. 1 is a perspective view of a semiconductor device 100 according to one or more embodiments. FIG. 2 is a cross-sectional view of the semiconductor device 100 taken along line I-I' of FIG. 1 according to one or more embodiments. The semiconductor device 100 illustrated in FIGS. 1 and 2 may be a fin field effect transistor (FinFET).

Referring to FIGS. 1 and 2, provided is a substrate 110. The substrate 10 may include various materials. For example, the substrate 110 may include a semiconductor material layer 111. The semiconductor material layer 111 may include a Group IV semiconductor, such as Si, Ge, SiGe, etc., or a Group III-V semiconductor compound. Furthermore, the semiconductor material layer 111 may include, for example, an oxide semiconductor, a nitride semiconductor, an oxynitride semiconductor, a two-dimensional (2D) semiconductor material, quantum dots, or an organic semiconductor. However, embodiments are not limited thereto. The semiconductor material layer 111 may include a p-type dopant or an n-type dopant. The substrate 110 may further include the insulating material layer 112. The insulating material layer 112 may include, for example, silicon oxide or the like, but embodiments are not limited thereto.

Although a case in which the substrate 110 includes the semiconductor material layer 111 and the insulating material layer 112 is described above, the substrate 110 may include various materials. For example, the substrate 110 may include a glass substrate or a semiconductor-on-insulator (SOI) substrate.

A channel layer 120 is arranged on the substrate 110. The channel layer 120 may have a fin shape protruding from an upper surface of the substrate 110. The channel layer 120 has a length in an x-axis direction, a width in a y-axis direction, and a height in a z-axis direction.

Portions of the channel layer 120 in the opposite sides of the channel layer 120 in the longitudinal direction (the x-axis direction) may be a source 121 and a drain 122, and a middle portion of the channel layer 120 between the source 121 and the drain 122 may be a channel. The channel layer 120 may include a semiconductor material. The channel layer 120 may include, for example, a semiconductor material forming the substrate 110. However, embodiments are not limited thereto. The channel layer 120 may include, for example, a Group IV semiconductor, such as Si, Ge, SiGe, etc., or a Group III-V semiconductor compound. The channel layer 120 may include, for example, an oxide semiconductor, a nitride semiconductor, an oxynitride semiconductor, a 2D semiconductor material, quantum dots, or an organic semiconductor. The oxide semiconductor may include, for example, InGaZnO or the like, the 2D semiconductor material may include, for example, transition metal dichalcogenide (TMD) or the like, and the quantum dots may include colloidal quantum dots (QD), a nanocrystal structure, or the like. However, embodiments are not limited thereto. The channel layer 120 may further include a dopant. The dopant may include a p-type dopant or an n-type dopant.

A gate electrode 130 is provided to surround the channel of the channel layer 120. The gate electrode 130 is provided to surround four sides of the channel layer 120. The gate electrode 130 may include an external gate electrode 131 and an internal gate electrode 132. The external gate electrode 131 may be provided to cover an upper surface of the channel layer 120 and opposite side surfaces of the channel layer 120 in the width direction of the channel layer 120. The internal gate electrode 132 may be provided to cover a lower surface of the channel layer 120 from below (e.g., the upper surface of the internal gate electrode 132 may contact a lower surface of the channel layer 120). The internal gate electrode 132 may be provided between the lower surface of the channel layer 120 and the upper surface of the substrate 110. A gate insulating layer may be provided between the external gate electrode 131 and the channel layer 120 and between the internal gate electrode 132 and the channel layer 120.

The external gate electrode 131 may include, for example, metal, metal nitride, metal oxide, or a combination thereof. The metal may include, for example, ruthenium (Ru), titanium (Ti), tantalum (Ta), niobium (Nb), iridium (Ir), molybdenum (Mo), tungsten (W), platinum (Pt), or the like. The metal nitride may include, for example, titanium nitride (TiN), tantalum nitride (TaN), niobium nitride (NbN), molybdenum nitride (MoN), cobalt nitride (CoN), tungsten nitride (WN), or the like. The metal oxide may include, for example, platinum oxide (PtO), iridium oxide (IrO₂), ruthenium oxide (RuO₂), strontium ruthenium oxide (SrRuO₃), barium strontium ruthenium oxide ((Ba,Sr)RuO₃), calcium ruthenium oxide (CaRuO₃), lanthanum strontium cobalt oxide ((La,Sr)CoO₃), or the like. The external gate electrode 131 may include highly doped polysilicon. The external gate electrode 131 may have a stack structure of a single material layer. As described below, the external gate electrode 131 may have a stack structure of a plurality of material layers.

The internal gate electrode 132 may include a heterogeneous material different from the external gate electrode 131. In detail, the internal gate electrode 132 may include a material having etch selectivity with respect to the external gate electrode 131. The internal gate electrode 132, like the external gate electrode 131, may include, for example, metal, metal nitride, metal oxide, a combination thereof, or highly doped polysilicon. However, embodiments are not limited thereto.

According to one or more embodiments, as the external gate electrode 131 is provided to cover the opposite side surfaces and an upper surface of the channel layer 120, and the internal gate electrode 132 is provided to cover the lower surface of the channel layer 120, the semiconductor device 100 in which the gate electrode 130 surrounds four sides of the channel layer 120 may be implemented. As such, as the internal gate electrode 132 is provided in the lower surface of the channel layer 120 (i.e., the internal gate electrode 132 covers remaining portions of the channel layer 120 that are not covered by the external gate electrode 131), leakage current occurring from the lower surface of the channel layer 120 may be additionally controlled. Due to the fin shape of the channel layer 120, the internal gate electrode 132 on the lower surface of the channel layer 120 affects the channel layer 120 less compared to the external gate electrode 131, and thus, a stable threshold voltage may be implemented even when the internal gate electrode 132 is formed of a heterogeneous material different from the external gate electrode 131. Furthermore, as in a semiconductor manufacturing process described below, by forming the internal gate electrode 132 with a material having etch selectivity with respect to the external gate electrode 131, an organic material of an etch mask may be prevented from remaining between the substrate 110 and the channel layer 120.

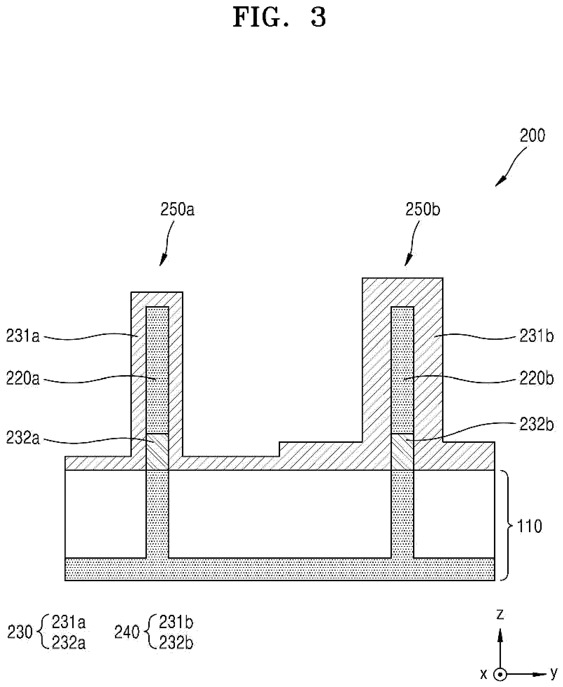

FIG. 3 is a cross-sectional view of a semiconductor device 200 according to one or more embodiments. The semiconductor device 200 illustrated in FIG. 3 may be a FinFET array including a plurality of FinFETs. FIG. 3 illustrates an example of the semiconductor device 200 including two FinFETs. In the following description, the differences from the embodiment described above are mainly described.

Referring to FIG. 3, the semiconductor device 200 may include first and second unit devices 250a and 250b spaced apart from each other on the substrate 110. The first and second unit devices 250a and 250b may each be a FinFET. The first and second unit devices 250a and 250b may be configured to have different threshold voltages from each other.

The first unit device 250a may include a first channel layer 220a arranged on the substrate 110, and a first gate electrode 230 provided to surround the first channel layer 220a. The first gate electrode 230 may include a first external gate electrode 231a arranged on opposite side surfaces and an upper surface of the first channel layer 220a, and a first internal gate electrode 232a arranged on a lower surface of the first channel layer 220a. As the substrate 110, the first channel layer 220a, the first external gate electrode 231a, and the first internal gate electrode 232a are the same as the substrate 110, the channel layer 120, the external gate electrode 131, and the internal gate electrode 132 illustrated in FIG. 2, descriptions thereof are omitted.

The second unit device 250b may include a second channel layer 220b arranged on the substrate 110 and a second gate electrode 240 provided to cover the second channel layer 220b. The second gate electrode 240 may include a second external gate electrode 231b arranged on opposite side surfaces and an upper surface of the second channel layer 220b and a second internal gate electrode 232b arranged on a lower surface of the second channel layer 220b. The second channel layer 220b and the second internal gate electrode 232b are respectively the same as the first channel layer 220a and the first internal gate electrode 232a. The second external gate electrode 231b may include the same material as the first external gate electrode 231a.

The second external gate electrode 231b may have a different thickness from the first external gate electrode 231a in a cross-sectional view across the y-axis. For example, the second external gate electrode 231b may be formed with a thicker thickness than the first external gate electrode 231a. As such, as the first and second external gate electrodes 231a and 231b have different thicknesses, and an elemental substance capable of adjusting a work function diffuses into the first and second external gate electrodes 231a and 231b, the first and second external gate electrodes 231a and 231b may be configured to have different threshold voltages.

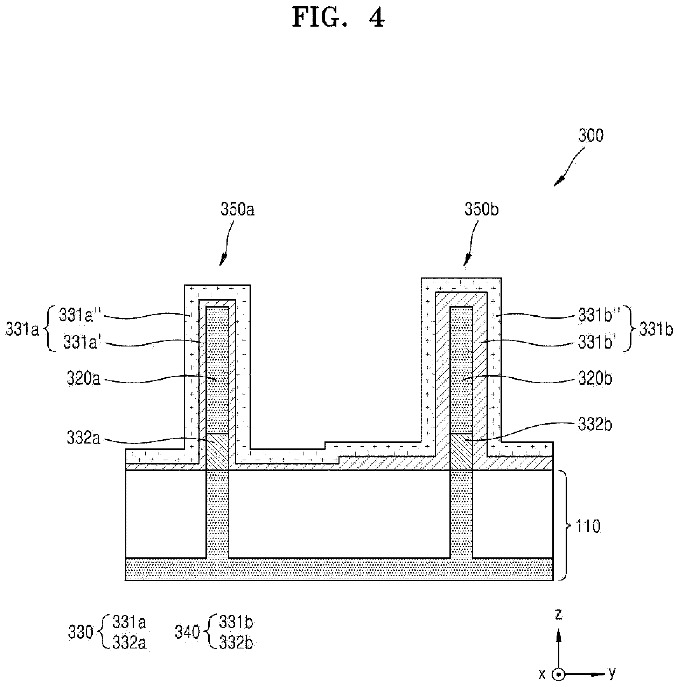

FIG. 4 is a cross-sectional view of a semiconductor device 300 according to one or more embodiments. Description of aspects that are the same as or similar to those described above may be omitted.

Referring to FIG. 4, a first unit device 350a may include a first channel layer 320a arranged on the substrate 110 and a first gate electrode 330 provided to surround the first channel layer 320a. The first gate electrode 330 may include a first external gate electrode 331a arranged on opposite side surfaces and an upper surface of the first channel layer 320a and a first internal gate electrode 332a arranged on a lower surface of the first channel layer 320a. The first external gate electrode 331a may include a first conductive layer 331a' arranged on the first channel layer 320a and a second conductive layer 331a" arranged on the first conductive layer 331a'. The first conductive layer 331a' of the first external gate electrode 331a may be the same as the first external gate electrode 231a of FIG. 3. The second conductive layer 331a" of the first external gate electrode 331a may include a different material from the first conductive layer 331a' of the first external gate electrode 331a.

The second unit device 350b may include a second channel layer 320b arranged on the substrate 110 and a second gate electrode 340 provided to surround the second channel layer 320b. The second gate electrode 340 may include a second external gate electrode 331b arranged on opposite side surfaces and an upper surface of the second external gate electrode 331b of the second channel layer 320b and a second internal gate electrode 332b arranged on a lower surface the second channel layer 320b. The second channel layer 320b and the second internal gate electrode 332b are respectively the same as the first channel layer 320a and the first internal gate electrode 332a.

The second external gate electrode 331b may include a first conductive layer 331b' arranged on the second channel layer 320b and a second conductive layer 331b" arranged on the first conductive layer 331b'. The first conductive layer 331b' of the second external gate electrode 331b may be the same as the second external gate electrode 231b of FIG. 3. Accordingly, the first conductive layer 331b' of the second external gate electrode 331b may have a different thickness from the first conductive layer 331a' of the first external gate electrode 331a.

The second conductive layer 331b" of the second external gate electrode 331b is the same as the second conductive layer 331a" of the first external gate electrode 331a. Accordingly, the second conductive layer 331b" of the second external gate electrode 331b may have the same thickness as the second conductive layer 331a" of the first external gate electrode 331a. The second conductive layer 331b" of the second external gate electrode 331b may include a different material from the first conductive layer 331b' of the second external gate electrode 331b. The second conductive layers 331a" and 331b" of the first and second external gate electrodes 331a and 331b may each include a material (e.g., Al, etc.) capable of adjusting a work function.

In one or more embodiments, the first conductive layer 331a' of the first external gate electrode 331a and the first conductive layer 331b' of the second external gate electrode 331b may be formed to have different thicknesses, and the second conductive layer 331a" of the first external gate electrode 331a and the second conductive layer 331b" of the second external gate electrode 331b may be formed to have the same thickness. When an elemental substance capable of adjusting a work function in the second conductive layers 331a" and 331b" diffuses into each of the first conductive layer 331a' of the first external gate electrode 331a and the first conductive layer 331b' of the second external gate electrode 331b, due to the thickness difference between the first conductive layers 331a' and 331b', the first external gate electrode 331a and the second external gate electrode 331b may be configured to have different threshold voltages.

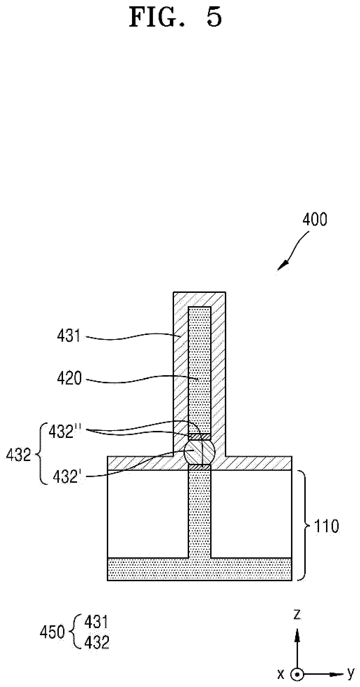

FIG. 5 is a cross-sectional view of a semiconductor device 400 according to one or more embodiments. The semiconductor device 400 illustrated in FIG. 5 may be a FinFET. Description of aspects that are the same as or similar to those described above may be omitted.

Referring to FIG. 5, a channel layer 420 is arranged on the substrate 110. The channel layer 420 may have a fin shape protruding from the upper surface of the substrate 110. The channel layer 420 has a length in the x-axis direction, a width in the y-axis direction, and a height in the z-axis direction. The channel layer 420 may include a semiconductor material. The channel layer 420 may include, for example, a Group IV semiconductor, such as Si, Ge, SiGe, etc., or a Group III-V semiconductor compound. The channel layer 420 may include, for example, an oxide semiconductor, a nitride semiconductor, an oxynitride semiconductor, a 2D semiconductor material, quantum dots, or an organic semiconductor. However, embodiments are not limited thereto. The channel layer 420 may further include a p-type dopant or an n-type dopant.

A gate electrode 450 may be provided to surround the channel layer 420. The gate electrode 450 is provided to surround four sides of the channel layer 420. The gate electrode 450 may include an external gate electrode 431 and an internal gate electrode 432. The external gate electrode 431 may be provided to cover an upper surface of the channel layer 420 and opposite side surfaces of the channel layer 420. The internal gate electrode 432 may be provided to cover a lower surface of the channel layer 420. The internal gate electrode 432 may be arranged between the lower surface of the channel layer 420 and the upper surface of the substrate 110. A gate insulating layer may be arranged between the external gate electrode 431 and the channel layer 420, and between the internal gate electrode 432 and the channel layer 420.

The external gate electrode 431 may include, for example, metal, metal nitride, metal oxide, a combination thereof, or highly doped polysilicon. The external gate electrode 431 may have a stack structure of a single material layer. Alternatively, the external gate electrode 431 may have a stack structure of a plurality of material layers.

The internal gate electrode 432 may include an internal conductive layer 432' and a barrier layer 432" arranged on each of an upper surface and a lower surface of the internal conductive layer 432'. The internal conductive layer 432' may include a heterogeneous material different from the external gate electrode 431. In detail, the internal conductive layer 432' may include a material having etch selectivity with respect to the external gate electrode 431. The internal conductive layer 432', like the external gate electrode 431, may include, for example, metal, metal nitride, metal oxide, a combination thereof, or highly doped polysilicon. However, embodiments are not limited thereto.

The barrier layer 432" may include a material that prevents diffusion of the material in the internal conductive layer 432' to the outside. The barrier layer 432" may include a different material from the internal conductive layer 432'. The barrier layer 432" may include a different material from the external gate electrode 431 or the same material as the external gate electrode 431. For example, when the internal conductive layer 432' includes W, the barrier layer 432" may include TiN. However, embodiments are not limited thereto.

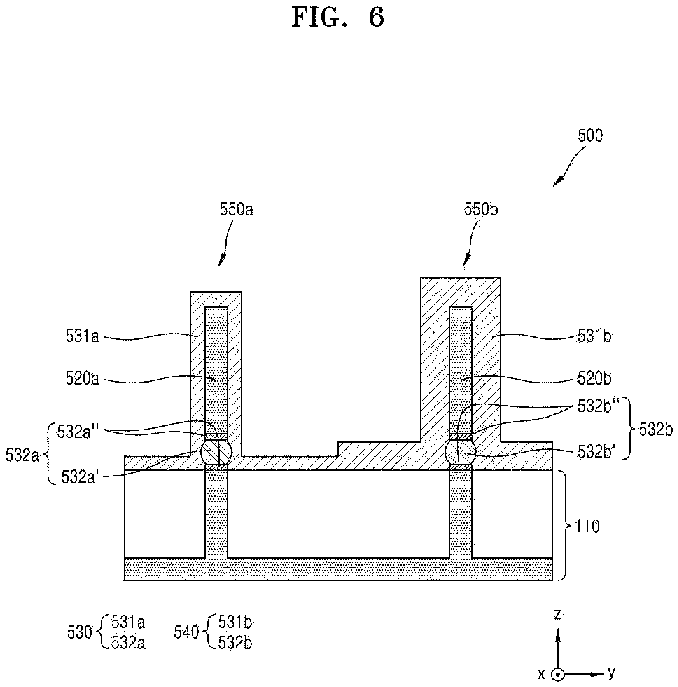

FIG. 6 is a cross-sectional view of a semiconductor device 500 according to one or more embodiments. The semiconductor device 500 illustrated in FIG. 6 may be a FinFET array including a plurality of FinFETs. FIG. 6 illustrates an example of the semiconductor device 500 including two FinFETs. Description of aspects that are the same as or similar to those described above may be omitted.

Referring to FIG. 6, the semiconductor device 500 may include first and second unit devices 550a and 550b spaced apart from each other on the substrate 110. The first and second unit devices 550a and 550b may each be a FinFET. The first and second unit devices 550a and 550b may be configured to have threshold voltages from each other.

The first unit device 550a may include a first channel layer 520a arranged on the substrate 110 and the first channel layer 520a provided to surround a first gate electrode 530. The first gate electrode 530 may include a first external gate electrode 531a arranged on opposite side surfaces and an upper surface of the first channel layer 520a and a first internal gate electrode 532a arranged on a lower surface of the first channel layer 520a. The first internal gate electrode 532a may include a first internal conductive layer 532a' and a first barrier layer 532a" arranged on each of an upper surface and a lower surface of the first internal conductive layer 532a'. The first channel layer 520a, the first external gate electrode 531a, and the first internal gate electrode 532a may be the same as the channel layer 420, the external gate electrode 431, and the internal gate electrode 432 illustrated in FIG. 5.

The second unit device 550b may include a second channel layer 520b arranged on the substrate 110 and a second gate electrode 540 provided to surround the second channel layer 520b. The second gate electrode 540 may include a second external gate electrode 531b arranged on opposite side surfaces and an upper surface of the second channel layer 520b and a second internal gate electrode 532b arranged on a lower surface of the second channel layer 520b. The second internal gate electrode 532b may include a second internal conductive layer 532b' and a second barrier layer 532b" arranged on each of an upper surface and a lower surface of the second internal conductive layer 532b'. The second channel layer 520b and the second internal gate electrode 532b are respectively the same as the first channel layer 520a and the first internal gate electrode 532a. The second external gate electrode 531b may include the same material as the first external gate electrode 531a.

The second external gate electrode 531b may have a different thickness from the first external gate electrode 531a. For example, the second external gate electrode 531b may be formed with a thicker thickness than the first external gate electrode 531a. As such, as the first and second external gate electrodes 531a and 531b are formed to have different thicknesses, and an elemental substance capable of adjusting a work function diffuses into the first and second external gate electrodes 531a and 531b, the first and second external gate electrodes 531a and 531b may be configured to have different threshold voltages. The first and second external gate electrodes 531a and 531b may each include, similarly to those illustrated in FIG. 4, a first conductive layer and a second conductive layer arranged on the first conductive layer.

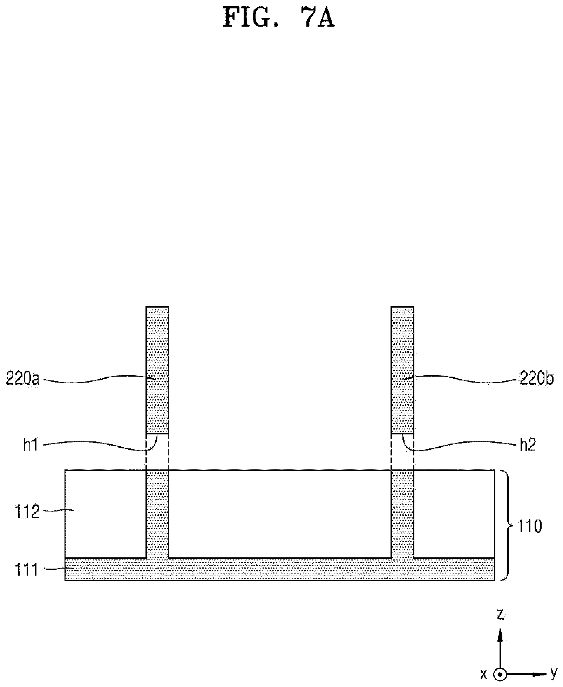

FIGS. 7A to 7F are cross-sectional views illustrating a method of fabricating a semiconductor device, according to one or more embodiments. FIGS. 7A to 7F illustrate an example of a method of fabricating the semiconductor device 200 illustrated in FIG. 3.

Referring to FIG. 7A, the first and second channel layers 220a and 220b are formed on the substrate 110 to extend perpendicularly. The substrate 110 may include the semiconductor material layer 111. The semiconductor material layer 111 may include a Group IV semiconductor, such as Si, Ge, SiGe, etc., or a Group III-V semiconductor compound. Furthermore, the semiconductor material layer 111 may include, for example, an oxide semiconductor, a nitride semiconductor, an oxynitride semiconductor, a 2D semiconductor material, quantum dots, or an organic semiconductor. However, embodiments are not limited thereto. A semiconductor material layer 111 may include a p-type dopant or an n-type dopant. The substrate 110 may further include the insulating material layer 112. The insulating material layer 112 may include, for example, silicon oxide or the like, but embodiments are not limited thereto.

The first and second channel layers 220a and 220b may each be formed in a fin shape protruding from the upper surface of the substrate 110. The first and second channel layers 220a and 220b may include the same material as the semiconductor material layer 111 of the substrate 110. For example, the first and second channel layers 220a and 220b may each include a Group IV semiconductor, such as Si, Ge, SiGe, etc., or a Group III-V semiconductor compound. Furthermore, the first and second channel layers 220a and 220b may each include, for example, an oxide semiconductor, a nitride semiconductor, an oxynitride semiconductor, a 2D semiconductor material, quantum dots, or an organic semiconductor. The first and second channel layers 220a and 220b may each include a p-type dopant or an n-type dopant. The first and second channel layers 220a and 220b may be formed by etching the semiconductor material layer 111 forming the substrate 110 into a certain shape.

Next, first and second through-holes h1 and h2 are formed in the first and second channel layers 220a and 220b, respectively. The first and second through-holes h1 and h2 may be formed in the direction (y-axis direction) parallel to the surface of the substrate 110 by respectively penetrating the first and second channel layers 220a and 220b. The first through-hole h1 may be formed between the upper surface of the substrate 110 and the lower surface of the first channel layer 220a, and the second through-hole h2 may be formed between the upper surface of the substrate 110 and the lower surface of the second channel layer 220b.

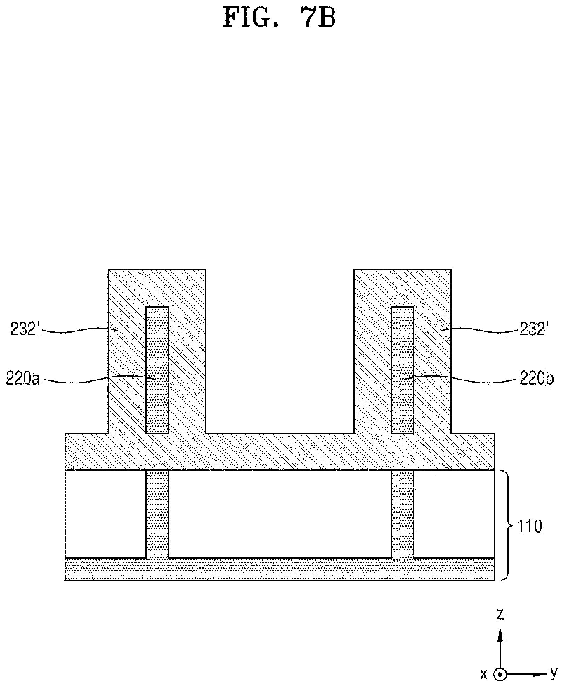

Referring to FIG. 7B, an internal gate material layer 232' is formed on the first and second channel layers 220a and 220b and the substrate 110 to fill the first and second through-holes h1 and h2. The internal gate material layer 232' may include, for example, metal, metal nitride, metal oxide, or a combination thereof. The metal may include, for example, Ru, Ti, Ta, Nb, Ir, Mo, W, Pt, or the like. The metal nitride may include, for example, TiN, TaN, NbN, MoN, CoN, WN, or the like. The metal oxide may include, for example, PtO, IrO₂, RuO₂, SrRuO₃, (Ba,Sr)RuO₃, CaRuO₃, (La,Sr)CoO₃, or the like. The internal gate material layer 232' may include highly doped polysilicon. The internal gate material layer 232' may include a material having etch selectivity with respect to a first external gate material layer 231' described below.

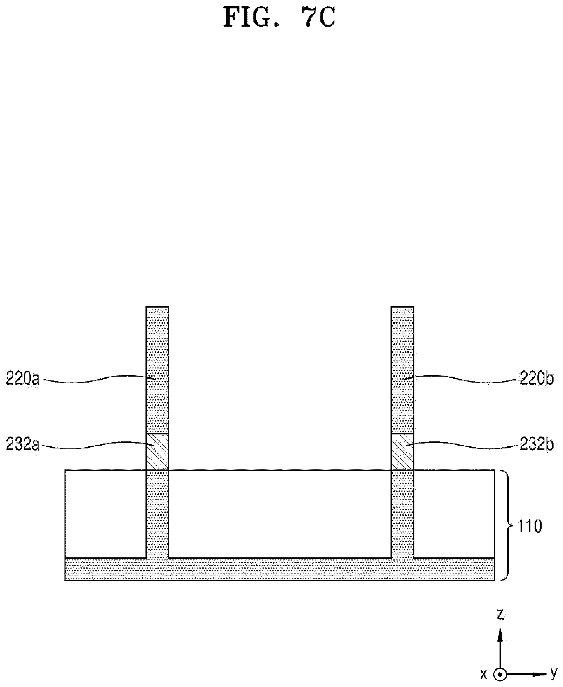

Referring to FIG. 7C, the internal gate material layer 232' is partially etched so as to be left only inside the first and second through-holes h1 and h2. Accordingly, the first internal gate electrode 232a may be formed to fill the first through-hole h1, and the second internal gate electrode 232b may be formed to fill the second through-hole h2.

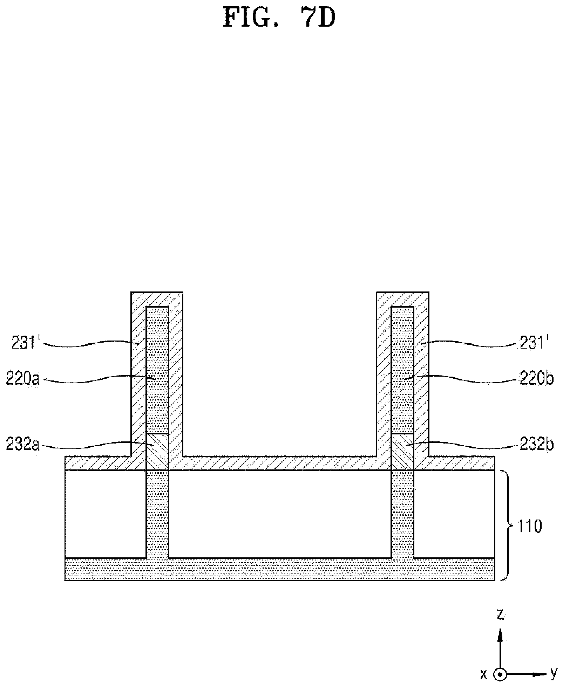

Referring to FIG. 7D, the first external gate material layer 231' is formed to cover the first channel layer 220a and the first internal gate electrode 232a, and the second channel layer 220b and the second internal gate electrode 232b. The first external gate material layer 231' may include a different material from the internal gate material layer 232'. In detail, the first external gate material layer 231' may include a material having etch selectivity with respect to the internal gate material layer 232'. The first external gate material layer 231' may include, for example, metal, metal nitride, metal oxide, a combination thereof, or highly doped polysilicon. However, embodiments are not limited thereto.

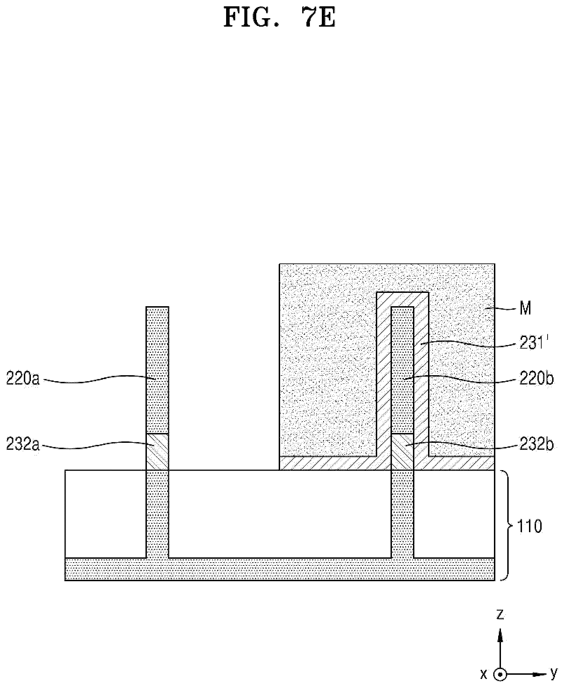

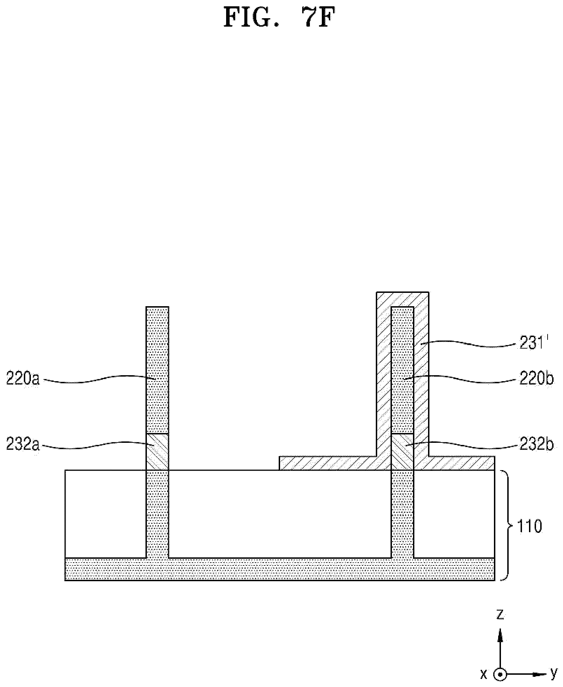

Referring to FIG. 7E, only the first external gate material layer 231' covering the first channel layer 220a and the first internal gate electrode 232a is selectively etched and removed. In detail, an etch mask M is formed, through patterning, to cover the first external gate material layer 231' formed on the second channel layer 220b and the second internal gate electrode 232b. The etch mask M may include, for example, a silicon-based or carbon-based organic material, but embodiments are not limited thereto. Next, only the first external gate material layer 231' covering the first channel layer 220a and the first internal gate electrode 232a is selectively etched by using the etch mask M. Next, referring to FIG. 7F, the etch mask M formed on the first external gate material layer 231' covering the second channel layer 220b and the second internal gate electrode 232b is removed.

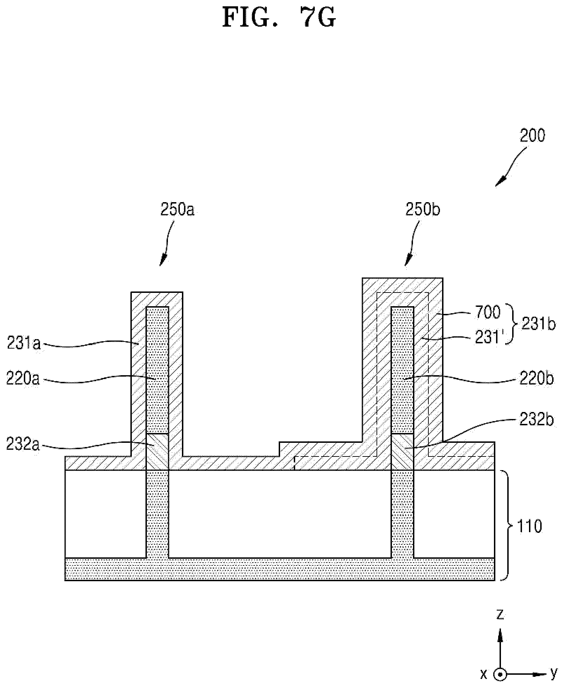

Referring to FIG. 7G, a second external gate material layer 700is formed to cover the structure illustrated in FIG. 7F. The second external gate material layer 700 may include the same material as the first external gate material layer 231'. The second external gate material layer 700 may be formed to cover the first external gate material layer 231' formed on the first channel layer 220a and the first internal gate electrode 232a, and on the second channel layer 220b and the second internal gate electrode 232b. The second external gate material layer 700 covering the first channel layer 220a and the first internal gate electrode 232a may be the first external gate electrode 231a. The first external gate material layer 231' and the second external gate material layer 700, both covering the second channel layer 220b and the second internal gate electrode 232b, may be formed as the second external gate electrode 231b. Accordingly, the second external gate electrode 231b may be formed with a thicker thickness than the first external gate electrode 231a. As such, the semiconductor device 200 including the first and second unit devices 250a and 250b arranged apart from each other on the substrate 110 may be fabricated. A conductive layer (not shown) including an elemental substance for adjusting a work function may be additionally formed on the first and second external gate electrodes 231a and 231b.

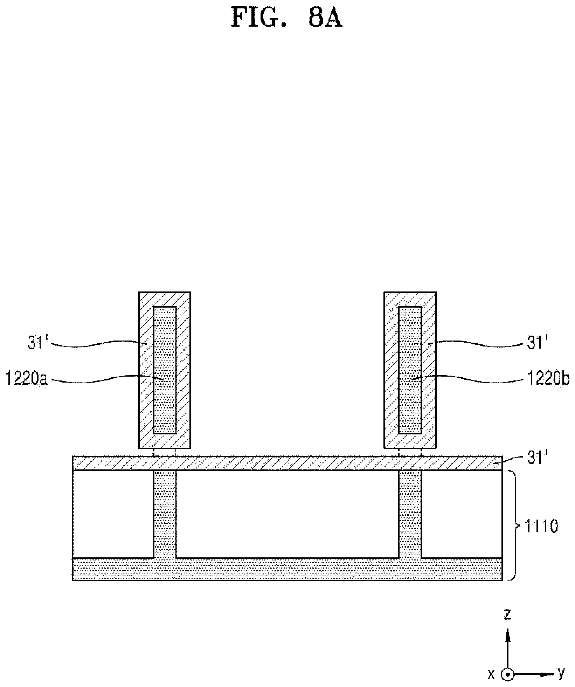

FIGS. 8A to 8C are cross-sectional views illustrating a method of fabricating a semiconductor device, according to a comparative example. FIGS. 8A to 8C illustrate an example of a problem that may occur when an internal gate electrode and an external gate electrode are formed as the same gate material layer in a semiconductor device fabrication process.

Referring to FIG. 8A, the first and second channel layers 1220a and 1220b are each formed in a fin shape perpendicularly extending from the substrate 1110, and then, first and second through-holes are formed in the first and second channel layers 1220a and 1220b, respectively. Next, a gate material layer 31' is formed on the first and second channel layers 1220a and 1220b and the substrate 1110. The gate material layer 31' may be formed to surround four sides of each of the first and second channel layers 1220a and 1220b. Although the gate material layer 31' is formed to fill the first and second through-holes, it is possible that, during the process, a gap is formed between the substrate 1110 and the gate material layer 31' formed on a lower surface of each of the first and second channel layers 1220a and 1220b.

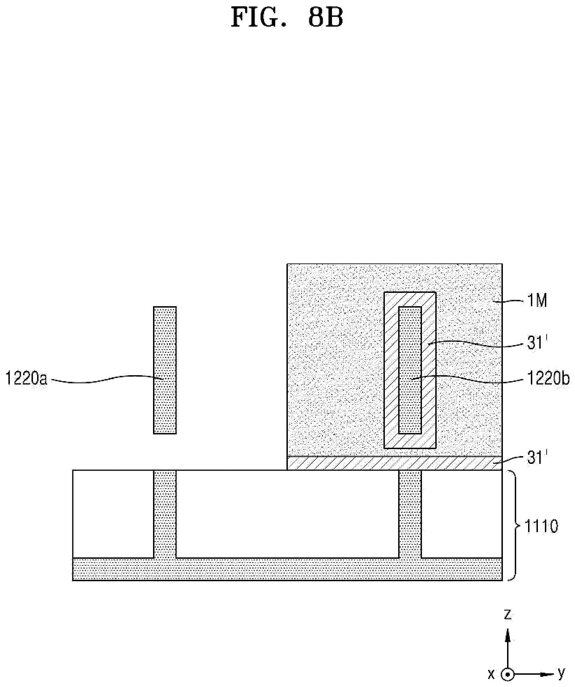

Referring to FIG. 8B, only the gate material layer 31' on the first channel layer 1220a is selectively etched and removed. In detail, the etch mask 1M is formed, through patterning, to cover the gate material layer 31' formed on the second channel layer 1220b. The etch mask 1M may include, for example, a silicon-based or carbon-based organic material, but embodiments are not limited thereto. Next, only the gate material layer 31' covering the first channel layer 1220a is selectively etched by using the etch mask 1M.

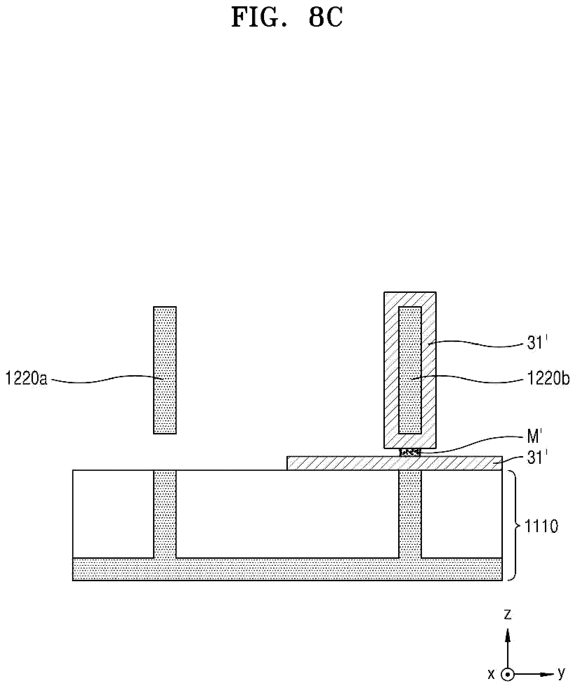

Referring to FIG. 8C, the etch mask 1M formed on the gate material layer 31' covering the second channel layer 1220b is removed. However, in the process of removing the etch mask 1M, a problem may occur in which an organic material M' of the etch mask 1M filling the gap between the gate material layer 31' formed on the lower surface of the second channel layer 1220b and the substrate 1110 remains as is.

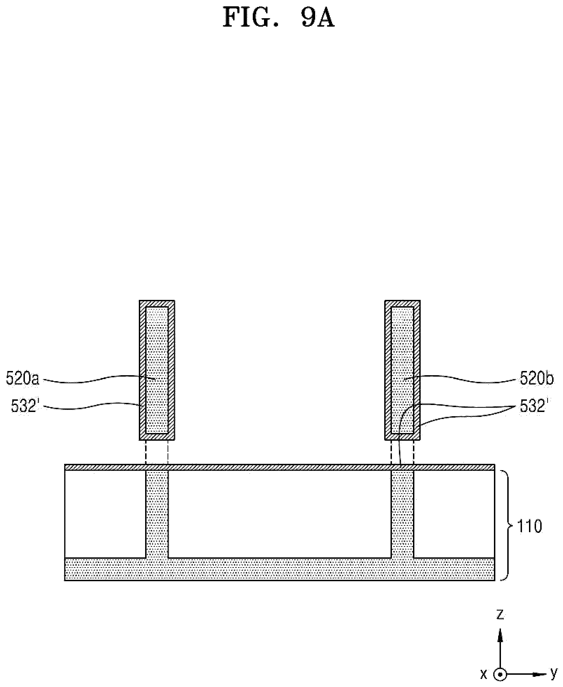

FIGS. 9A to 9H are cross-sectional views illustrating a method of fabricating a semiconductor device, according to one or more embodiments. FIGS. 9A to 9H illustrate an example of a method of fabricating the semiconductor device 500 illustrated in FIG. 6.

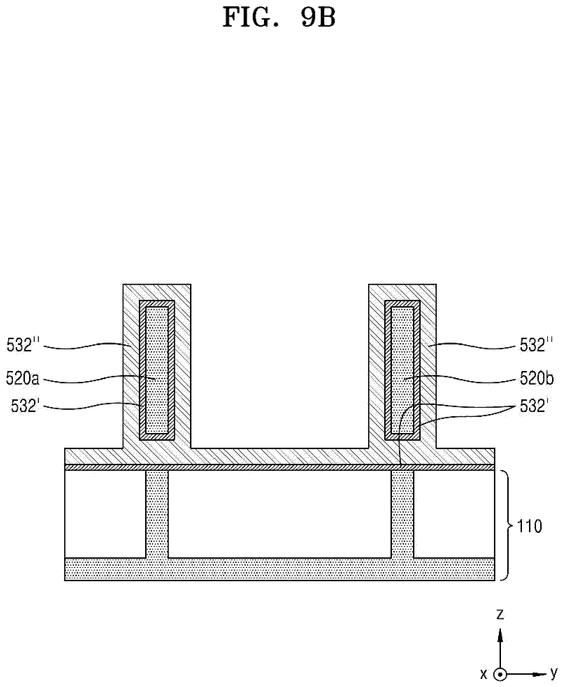

Referring to FIG. 9A, the first and second channel layers 520a and 520b are each formed in a fin shape perpendicularly extending from the substrate 110, and then, first and second through-holes are formed in the first and second channel layers 520a and 520b, respectively. The first and second through-holes may be formed in a direction parallel to the surface of the substrate 110 by penetrating the first and second channel layers 520a and 520b. Next, a barrier material layer 532' is formed on surfaces of the first and second channel layers 520a and 520b and the upper surface of the substrate 110. The barrier material layer 532' may be formed to surround four sides of each of the first and second channel layers 520a and 520b and cover the upper surface of the substrate 110. The barrier material layer 532' may include a material that prevents diffusion of an internal conductive material layer (532" in FIG. 9B) described below.

Referring to FIG. 9B, an internal conductive material layer 532" is formed on the barrier material layer 532' that is formed on the first and second channel layers 520a and 520b and the substrate 110. The internal conductive material layer 532" may include a different material from the barrier material layer 532'. Furthermore, the internal conductive material layer 532" may include a material having etch selectivity with respect to a first external gate material layer 531' described below. The internal conductive material layer 532" may include, for example, metal, metal nitride, metal oxide, a combination thereof, or highly doped polysilicon.

The internal conductive material layer 532" may be formed to fill areas between the first and second channel layers 520a and 520b and the substrate 110. Accordingly, a gap between the first and second channel layers 520a and 520b and the substrate 110 may be filled with the internal conductive material layer 532" and the barrier material layer 532' formed on an upper surface and a lower surface of the internal conductive material layer 532".

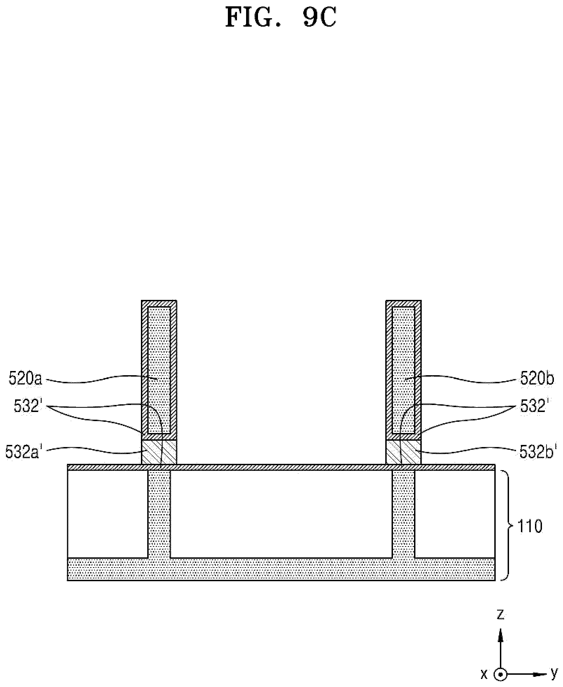

Referring to FIG. 9C, the internal conductive material layer 532" is partially etched so that the internal conductive material layer 532" are left only between the first and second channel layers 520a and 520b and the substrate 110.

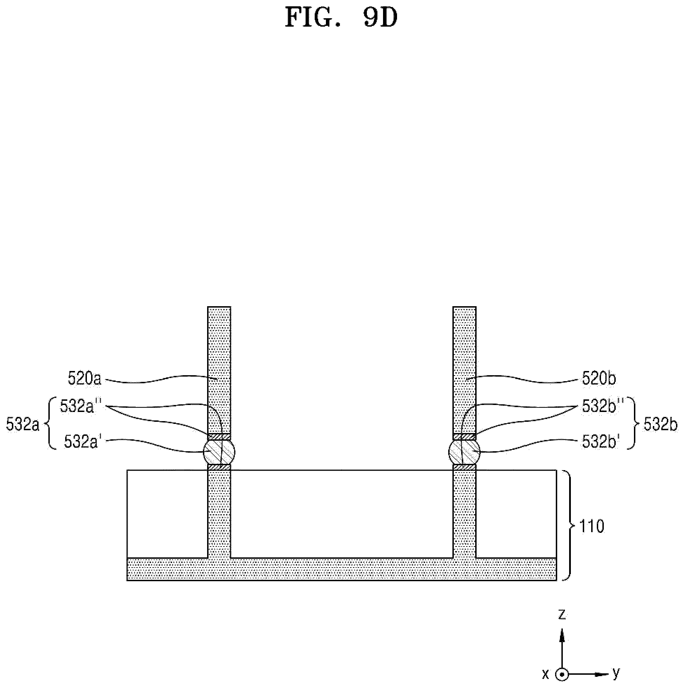

Next, referring to FIG. 9D, the barrier material layer 532' is partially etched so that the barrier material layer 532' is left only between the first and second channel layers 520a and 520b and the substrate 110. Accordingly, the first internal gate electrode 532a may be formed between the lower surface of the first channel layer 520a and the upper surface of the substrate 110. The first internal gate electrode 532a may include the first internal conductive layer 532a' and the first barrier layer 532a" arranged on each of an upper surface and a lower surface of the first internal conductive layer 532a'. The second internal gate electrode 532b may be formed between the lower surface of the second channel layer 520b and the upper surface of the substrate 110. The second internal gate electrode 532b may include the second internal conductive layer 532b' and the second barrier layer 532b" arranged on each of an upper surface and a lower surface of the second internal conductive layer 532b'.

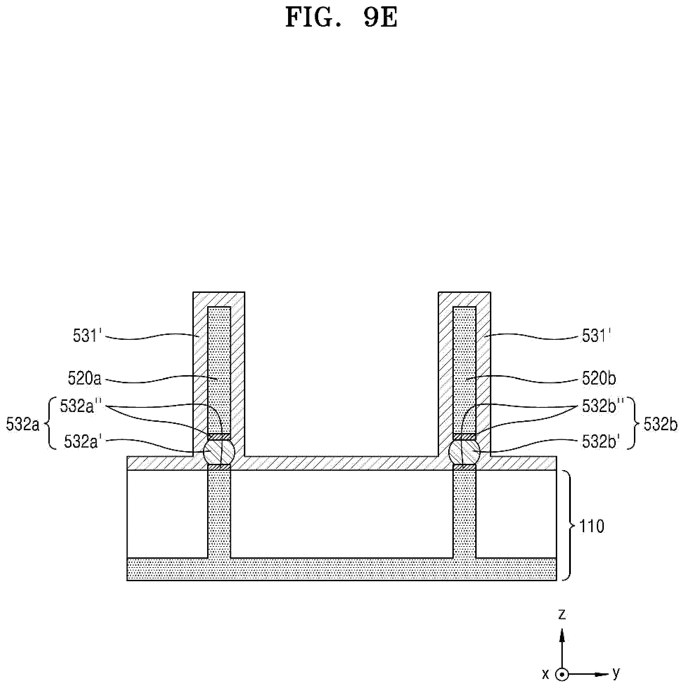

Referring to FIG. 9E, a first external gate material layer 531' is formed to cover the first channel layer 520a and the first internal gate electrode 532a, and the second channel layer 520b and the second internal gate electrode 532b. The first external gate material layer 531' may include a different material from an internal conductive material layer 532" described above. In detail, the first external gate material layer 531' may include a material having etch selectivity with respect to the internal conductive material layer 532". The first external gate material layer 531' may include, for example, metal, metal nitride, metal oxide, a combination thereof, or highly doped polysilicon. However, embodiments are not limited thereto.

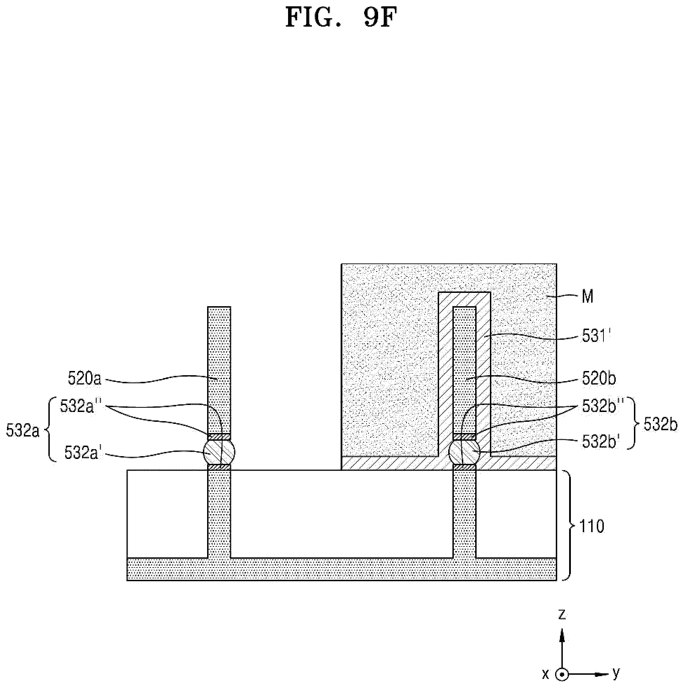

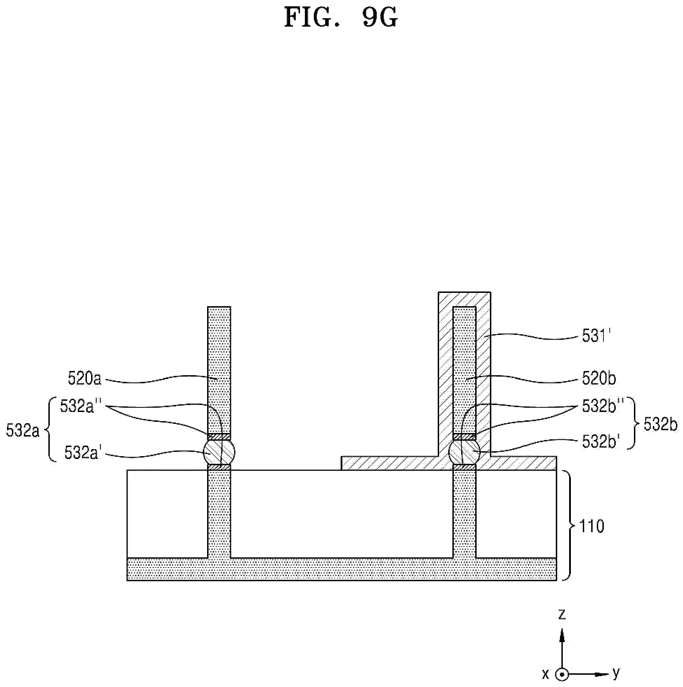

Referring to FIG. 9F, only the first external gate material layer 531' covering the first channel layer 520a and the first internal gate electrode 532a is selectively etched and removed. In detail, the etch mask M is formed, through patterning, to cover the first external gate material layer 531' formed on the second channel layer 520b and the second internal gate electrode 532b. The etch mask M may include, for example, a silicon-based or carbon-based organic material, but embodiments are not limited thereto. Next, only the first external gate material layer 531' covering the first channel layer 520a and the first internal gate electrode 532a is selectively etched by using the etch mask M. Next, referring to FIG. 9G, the etch mask M formed on the first external gate material layer 531' covering the second channel layer 520b and the second internal gate electrode 532b is removed.

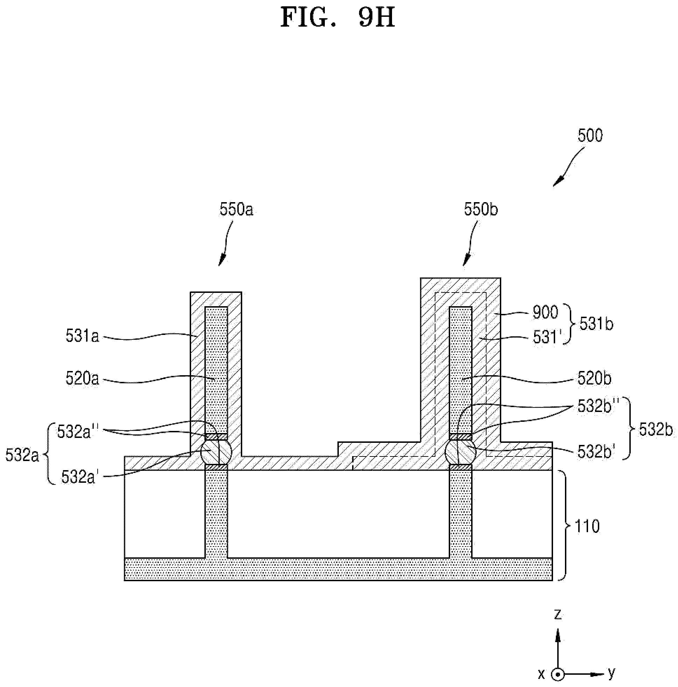

Referring to FIG. 9H, a second external gate material layer 900 is formed to cover the structure illustrated in FIG. 9G. The second external gate material layer 900 may include the same material as the first external gate material layer 531'. The second external gate material layer 900 may be formed to cover the first external gate material layer 531' formed on the first channel layer 520a and the first internal gate electrode 532a, and on the second channel layer 520b and the second internal gate electrode 532b. The second external gate material layer 900 covering the first channel layer 520a and the first internal gate electrode 532a may be the first external gate electrode 531a. The first external gate material layer 531' and the second external gate material layer 900, both covering the second channel layer 520b and the second internal gate electrode 532b, may be formed as the second external gate electrode 531b. Accordingly, the second external gate electrode 531b may be formed with a thicker thickness than the first external gate electrode 531a. As such, the semiconductor device 500 including the first and second unit devices 550a and 550b arranged apart from each other on the substrate 110 may be fabricated. A conductive layer (not shown) including an elemental substance for adjusting a work function may be additionally formed on the first and second external gate electrodes 531a and 531b.

According to one or more embodiments described above, as the external gate electrode is provided to cover the opposite side surfaces and the upper surface of the channel layer, and the internal gate electrode is provided to cover the lower surface of the channel layer, a semiconductor device in which the gate electrode surrounds four sides of the channel layer may be implemented. As such, as the internal gate electrode, other than the external gate electrode, is arranged on the lower surface of the channel layer, leakage current occurring from the lower surface of the channel layer may be additionally controlled. Due to the fin shape of the channel layer, the internal gate electrode on the lower surface of the channel layer affects the channel layer less compared to the external gate electrode, and thus, a stable threshold voltage may be implemented even when the internal gate electrode is formed of a heterogeneous material different from the external gate electrode. Furthermore, in the semiconductor manufacturing process, as the internal gate electrode is formed of a material having etch selectivity with respect to the external gate electrode, an organic material of an etch mask may be prevented from remaining between the substrate and the channel layer.

Each of the embodiments provided in the above description is not excluded from being associated with one or more features of another example or another embodiment also provided herein or not provided herein but consistent with the disclosure.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. A semiconductor device comprising:
a substrate;
a channel layer having a fin shape and protruding from the substrate in a first direction perpendicular to an upper surface of the substrate;
an external gate electrode on a first side surface of the channel layer, a second side surface of the channel layer that is opposite to the first side surface, and an upper surface of the channel layer; and
an internal gate electrode contacting a lower surface of the channel layer,
wherein the internal gate electrode comprises a material that is different from a material from of the external gate electrode.

2. The semiconductor device of claim 1, wherein the material of the internal gate electrode has etch selectivity with respect to the external gate electrode.

3. The semiconductor device of claim 1 or 2, wherein the material of the internal gate electrode and the material of the external gate electrode comprise at least one of metal, metal nitride, metal oxide, and doped polysilicon.

4. The semiconductor device of any preceding claim, wherein the external gate electrode comprises a first conductive layer on the channel layer and a second conductive layer on the first conductive layer.

5. The semiconductor device of any preceding claim, wherein the channel layer comprises a Group IV semiconductor, a Group III-V semiconductor compound, an oxide semiconductor, a nitride semiconductor, an oxynitride semiconductor, a two-dimensional semiconductor, quantum dots, or an organic semiconductor.

6. The semiconductor device of any preceding claim, wherein the internal gate electrode comprises:
an internal conductive layer comprising a material that is different from the material of the external gate electrode; and
a barrier layer on an upper surface of the internal conductive layer and a lower surface of the internal conductive layer.

7. A semiconductor device comprising:
a substrate;
a first unit device according to any preceding claim; and
a second unit device according to any preceding claim, wherein the first unit device and second unit device share the same substrate and are spaced apart.

8. The semiconductor device of claim 7, wherein, in a second direction that is perpendicular to the first direction, a thickness of the external gate electrode of the first unit device is different from a thickness of the external gate electrode of the second unit device.

9. The semiconductor device of claim 7, wherein, in a second direction that is perpendicular to the first direction, a thickness of the first conductive layer of the first unit device is different from a thickness of the first conductive layer of the second unit device.

10. A method of fabricating a semiconductor device, the method comprising:
forming a first channel layer and a second channel layer on a substrate that extend in a first direction perpendicular to an upper surface of the substrate;
forming a first through-hole in a lower of the first channel layer and a second through-hole in a lower portion of the second channel layer;
forming a first internal gate electrode filling the first through-hole and a second internal gate electrode filling and the second through-hole;
forming a first external gate material layer on the substrate, the first external gate material layer covering the first channel layer, the first internal gate electrode, the second channel layer and the second internal gate electrode;
selectively etching and removing the first external gate material layer in areas in which the first external gate material layer covers the first channel layer and the first internal gate electrode;
forming a second external gate material layer on the first external gate material layer covering the first channel layer, the first internal gate electrode, the second channel layer, and the second internal gate electrode;
forming a first external gate electrode on the first channel layer and the first internal gate electrode; and
forming a second external gate electrode on the second channel layer and the second internal gate electrode,
wherein the first internal gate electrode comprises a material that is different from a material of the first external gate electrode, and the second internal gate electrode comprises a material that is different from a materials of the second external gate electrode.

11. The method of claim 10, wherein a thickness of the second external gate electrode is different from a thickness of the first external gate electrode.

12. The method of claim 10 or 11, wherein the first through-hole and the second through-hole are formed in a second direction that is perpendicular to the first direction.

13. The method of claim 10, 11 or 12, wherein the forming the first internal gate electrode and the second internal gate electrode comprises:
forming an internal gate material layer in each of the first channel layer and the second channel layer to fill the first through-hole and the second through-hole; and
etching and removing the internal gate material layer such that the internal gate material layer remains only in the first through-hole and the second through-hole.

14. The method of claim 13, wherein the internal gate material layer comprises a material having etch selectivity with respect to the first external gate material layer.

15. The method of any of claims 10 to 14, wherein the first internal gate electrode comprises a first internal conductive layer comprising a material that is different from the material of the first external gate electrode and a barrier layer on an upper surface of the first internal conductive layer and a lower surface of the first internal conductive layer, and
wherein the second internal gate electrode comprises a second internal conductive layer comprising a material that is different from the material of the second external gate electrode and a barrier layer on an upper surface of the second internal conductive layer and a lower surface of the second internal conductive layer.
